# EUROPEAN PATENT SPECIFICATION

(11) **EP 0 424 053 B1**
(45) Date of publication and mention of the grant of the patent: **27.12.1995**
(21) Application number: 90311239.9
(22) Date of filing: 15.10.1990
(51) Int. Cl.: G03G 15/20

(54) **Mold releasing elastic roller**
Adhäsionsfreie elastische Walze
Rouleau élastique anti-adhésif

(30) Priority: 16.10.1989 JP 269574/89; 10.09.1990 JP 240490/90; 10.09.1990 JP 240491/90
(43) Date of publication of application: 24.04.1991
(73) Proprietor: CANON KABUSHIKI KAISHA, Tokyo (JP)
(72) Inventor: Mizunuma, Noboru, Shimomaruko, Ohta-ku, Tokyo (JP); Naruse, Haruo, Shimomaruko, Ohta-ku, Tokyo (JP); Kawakami, Ikuyo, Shimomaruko, Ohta-ku, Tokyo (JP)
(74) Representative: Beresford, Keith Denis Lewis

(56) References cited:
- EP-A- 0 254 269
- EP-A- 0 321 162
- US-A- 4 179 601
- US-A- 4 320 714
- US-A- 4 550 243
- US-A- 4 819 020
- PATENT ABSTRACTS OF JAPAN, vol. 13, no. 203 (P-870)(3551), 15th May 1989;& JP-A-1 24 284
- PATENT ABSTRACTS OF JAPAN, vol. 12, no. 25 (P-659)(2872), 26th January 1988;& JP-A-62 178 290
- PATENT ABSTRACTS OF JAPAN, vol. 12, no. 443 (P-790)(3290), 22nd November 1988;& JP-A-63 173 085

## Description

### BACKGROUND OF THE INVENTION

### Field of the Invention

The present invention relates to a roller excellent in elasticity and in mold releasing ability, and more particularly to a fixing roller for fixing a toner image by applying at least pressure thereto and a fixing device utilizing such roller.

### Related Background Art

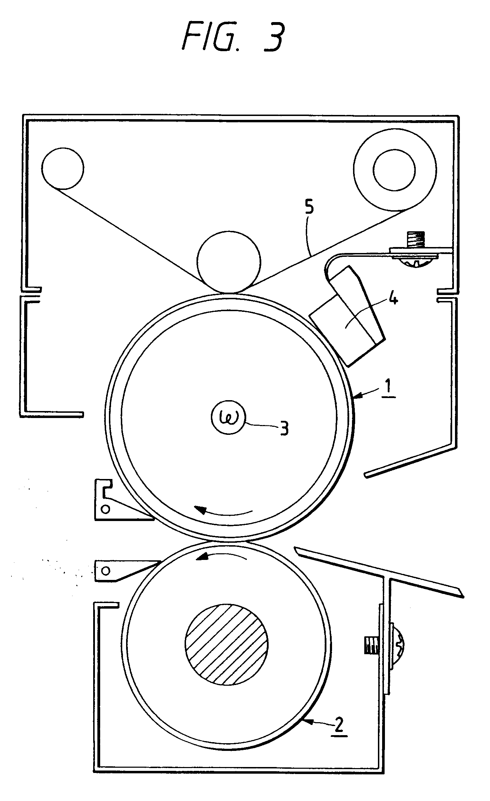

Although various image fixing devices have been proposed and practiced, there is principally employed, at present, so-called heat roller fixing device consisting of paired rollers having a heat source in at least one of said rollers, as shown in Fig. 3, in consideration of the thermal efficiency. In such fixing device, a heating roller 1 having a heat source (halogen lamp in this case) 3 and coming into contact with the unfixed toner and a pressure roller 2 usually having an elastic layer are maintained in pressure contact with a suitable nip width, and are rotated by drive means (not shown) in directions indicated by arrows. The surface temperature of the heating roller 1 is detected by a thermistor 4 and is maintained at an appropriate value. Upon passing of a recording sheet bearing an unfixed toner image thereon between said paired rollers, the thermofusible toner on said sheet is fixed by heat and pressure. The thermal conduction in such device is significantly better than in other fixing methods, because of direct contact of the toner with the fixing roller equipped with heat source therein.

However, such heat roller fixing method is associated with an offset phenomenon, or the transfer of toner onto the roller. Said offset phenomenon is caused by a temperature factor, including low-temperature offsetting resulting from lowering of the surface temperature of the heating roller and high-temperature offsetting resulting from elevation of said surface temperature, and an electrostatic factor, resulting from attraction or repulsion between the surface potential of the roller and the charge of the toner.

Said temperature factor can be eliminated by precise control of the surface temperature of the heating roller, but the electrostatic factor is difficult to eliminate.

In order to reduce the surface potential of the heating roller, it has been proposed to compose the surfacial layer of the heating roller with a material of low resistance and to ground said surface layer.

This arrangement is proposed in Japanese Laid Open Specification No. JP-A-1-24284 (RICOH CO. LTD).

The surface of the pressure roller is also required to have excellent releasing ability for the toner and to be flexible under pressure to form a satisfactory nip.

Said pressure roller, maintained in pressure contact with said heating roller, may also be charged up by frictional charging, and may lead to electrostatic offsetting of the toner.

However, if a material of low resistance is contained in the surface layer of the pressure roller, as suggested in the above specification, in order to prevent the charging thereof, the releasing ability of the surface is lessened, so that the surface of the pressure roller can be smeared by toner adhesion after the fixing of a large number of sheets. In an even worse case, the toner on the roller surface is again offset onto the rear surface of the copy sheet, thus smearing said rear surface.

Such phenomenon is particularly evident in a two side or both-face image forming apparatus in which the pressure roller comes into contact with the toner after fixing, and a device lacking the cleaning mechanism for the pressure roller.

For this reason there is employed a charge eliminating brush, but such brush cannot provide enough effect for preventing the charge generation at the nip of the rollers, and looses the charge eliminating ability when the brush is smeared with toner or paper dust.

Thus the present invention is concerned with providing an elastic roller with limited elevation of the surface potential.

U.S. Patent Specification No. 4,320,714 discloses a pressure roller having a grounded aluminum layer for reducing surface potential.

Accordingly the present invention provides a mold releasing roller as set out in claim 1.

Embodiments of the present invention will now be described by way of example and with reference to the accompanying drawings, in which:
Fig. 1 is a schematic cross-sectional view of a fixing device embodying the present invention;
Fig. 2 is a cross-sectional view of a pressure roller employed in the embodiment shown in Fig. 1;
Fig. 3 is a cross-sectional view of a conventional fixing device;
Fig. 4A is a schematic chart representing the state of a conventional pressure roller, Fig. 4B is a schematic chart representing the state of the pressure roller shown in Fig. 2; and
Fig. 5 is a cross-sectional view of another embodiment of the fixing device of the present invention.

Protection is sought only for the embodiments covered by the claims.

In the attached drawings, components of equivalent functions are represented by a same number.

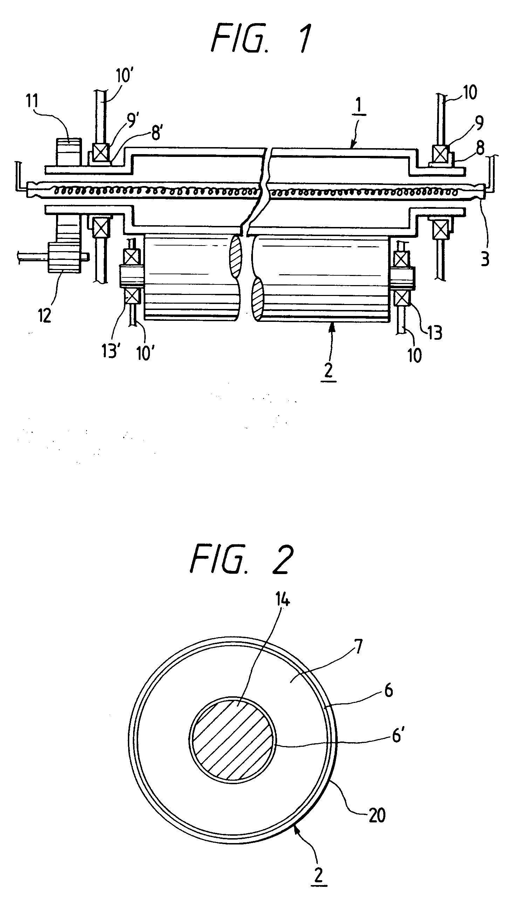

Fig. 1 is a cross-sectional view of an embodiment of the fixing device of the present invention, wherein a heating roller 1 is composed of a conductive core (stainless steel, aluminum etc.) and a tetrafluoroethylene resin layer formed thereon and containing a material of low resistance such as carbon black. The heating roller 1 is provided therein with a halogen heater 3, and is rotatably supported, by means of heat-resistant conductive resinous members 8, 8′ and ball bearings 9, 9′, on side plates 10, 10′, of the fixing device. Said roller is extended, at the far side (left side in Fig. 1), beyond the side plate, and the metal core is fitted with a gear 11 of heat-resistant insulating resin. Said gear 11 meshes with a driving gear 12 of drive means (not shown) and serves to rotate the roller 1.

On the other hand, a pressure roller 2 is also rotatably supported on the side plates 10, 10′, by means of slidable bearings 13, 13′. It is pressed to the heating roller 1 with an appropriate pressure exerted by pressurizing means (not shown), and is rotated by said heating roller 1.

Fig. 2 is a cross-sectional view of the pressure roller of the embodiment shown in Fig. 1.

A filler-free pure fluorinated resin (for example perfluoroalkoxy (PFA) resin) layer 20 is adhered, by a primer layer 6, onto an insulating rubber layer 7, which is preferably composed of silicone rubber but may be composed also of fluorinated rubber or a mixture of fluorinated rubber and silicone rubber.

The primer 6 is composed of rubber or resinous adhesive material in which a material of low resistance (for example carbon fibers, graphite whiskers, silicon carbide fibers, silicon carbide whiskers, a metal oxide such as titanium oxide, or nickel) is mixed to reduce the volume resistivity. For adhering the rubber layer 7 to the metal core 14 there is also employed primer 6′, which may be same as the above-mentioned primer 6 but is preferably free from the low-resistance material.

Although not shown in Fig. 1, a thermistor 4 for detecting the surface temperature and a cleaning web 5 are maintained in contact with the heating roller as shown in Fig. 3.

In the following there will be explained the effect of the embodiment shown in Fig. 1, in comparison with a reference example in which the primer layer 6 is made insulating.

Table 1 compares the embodiment of the present invention with the case utilizing a conventional pressure roller, by the amount of toner off-setting in consecutive fixing of 60 copies obtained from a lined business form original.

In this comparison the fixing operation is conducted on unfixed toner image, formed by developing a negatively chargeable organic photoconductive member with positively charged toner and transferred onto a recording sheet.

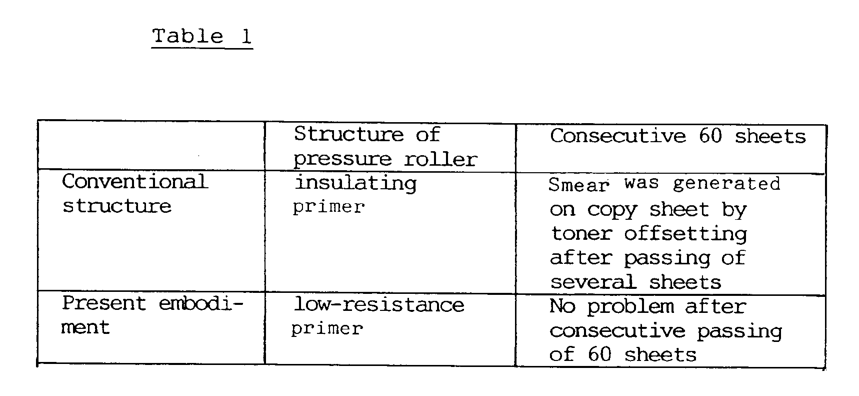

Table 2 shows the surface charge state of the pressure roller employed in the experiment shown in Table 1.

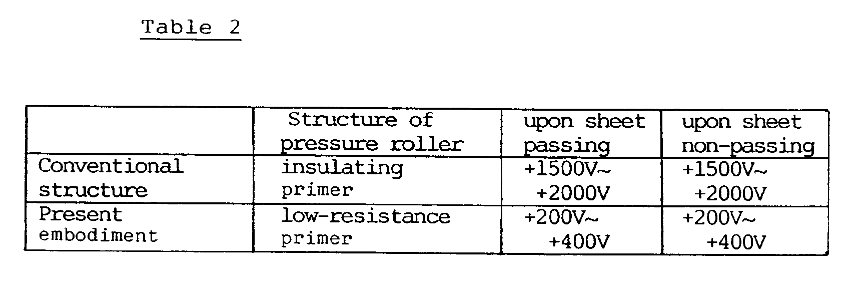

As shown in Table 2, while the roller utilizing insulating primer is positively charged to several thousand volts, the roller of the present embodiment is charged only to +400V at maximum, or about +200V at minimum.

These results indicate that a pressure roller, which has a tendency of being positively charged, can be excessively charged positively. On the other hand, the transfer sheet and toner in friction contact with the roller are also charged in same (positive) polarity. It is therefore estimated that the toner is pressed to the heating roller due to the strong electrostatic repulsion from the pressure roller, is separated from the transfer sheet even if completely fused and is offset to the heating roller. This tendency becomes naturally stronger in positively charged toner.

However the pressure roller of the present embodiment, containing a low-resistance material in the primer 6 and characterized by the low surface potential, is almost free from the electrostatic repulsion for pushing the toner toward the heating roller 1, thereby reducing the offsetting of toner.

The reduction of the surface potential of the pressure roller by the presence of a low-resistance primer layer between the insulating rubber layer and the surfacial releasing layer can be analyzed in the following manner.

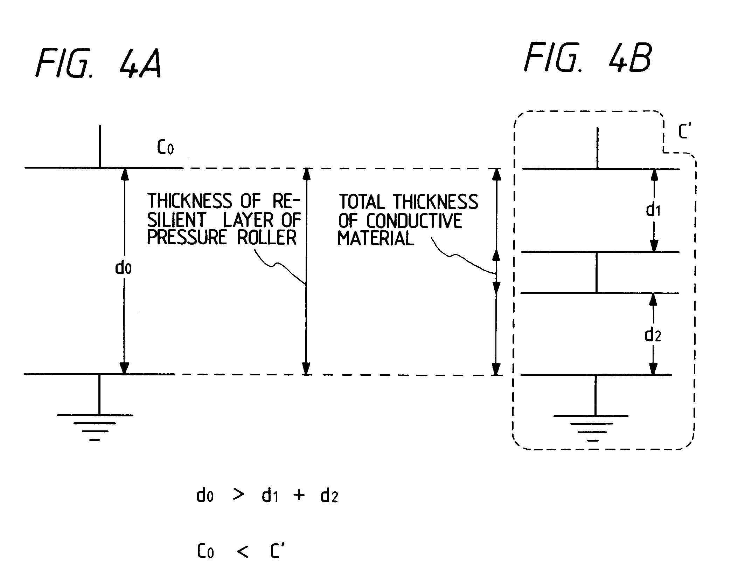

A roller employing insulating primer can be represented by a capacitor model shown in Fig. 4A, while the roller of the present embodiment can be represented by a capacitor model shown in Fig. 4B. In comparison with the model of the roller employing insulating primer (Fig. 4A), the model of the roller of the present embodiment (Fig. 4B) has a relatively smaller thickness of the capacitor due to the presence of dispersed low-resistance material, whereby the capacitance C increases by:$\text{C =} \frac{\text{εS}}{\text{d}}$
wherein d is the thickness of capacitor; ε is dielectric constant; and S is area. When a same amount of charge is given to these capacitors, the latter model shows smaller voltage V according to:$\text{V =} \frac{\text{Q}}{\text{C}}$
wherein Q is the charge and C is the capacitance. Thus the latter model shows a lower surface potential.

In case the surfacial insulating and releasing layer is composed of fluorinated resin, the thickness thereof is preferably equal to or less than 50 »m, because a larger thickness may suppress the internal elasticity. Also the resistivity of the primer layer is preferably not more than 10³ Ω·cm, more preferably not more than 10 Ω·cm.

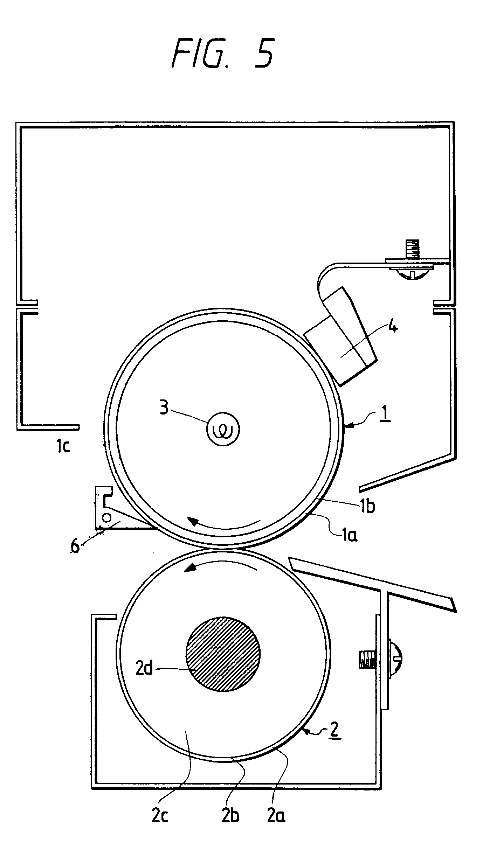

In the following there will be explained another embodiment of the present invention with reference to Fig. 5, showing a fixing device constituting said embodiment in a cross sectional view.

A thermistor 4 is provided for detecting the surface temperature of a fixing roller 1, and a temperature control circuit (not shown) controls the current supply to the halogen lamp according to the output from said thermistor, thereby maintaining the surface of the fixing roller 1 at a predetermined temperature.

In the vicinity of the nip formed by the fixing roller 1 and the pressure roller 2, there is provided a separating finger 6 maintained in contact with said fixing roller 1. The fixing roller 1 of the present is composed of a metal core 1c of stainless steel or aluminum of high thermal conductivity, and a releasing layer 1a of a thickness of 15 ∼ 70 »m of filler-free pure tetrafluoroethylene-alkylvinylether copolymer (PFA) resin, adhered to said core 1c by a primer layer 1b.

The fixed recording sheet is separated from the fixing roller 1, by means of the separating finger 6 maintained in pressure contact, at a predetermined position on the periphery of the fixing roller 1, by means of pressurizing means (not shown) such as a spring.

The pressure roller 2 is composed of a metal core 2d, an insulating rubber layer 2c formed thereon, and a surfacial releasing layer 2a composed of filler free pure fluorinated resin (for example perfluoroalkoxy (PFA) resin) and adhered to said rubber layer 2c by a primer layer 2b. Said rubber layer is preferably composed of silicone rubber, but may also be composed of fluorinated rubber or a mixture of fluorinated rubber and silicone rubber.

The primer 2b is composed of a rubber or resinous adhesive material in which a material of low resistance (for example carbon fibers, graphite whiskers, silicon carbide fibers, silicon carbide whiskers, a metal oxide such as titanium oxide or nickel) is mixed to reduce the volume resistivity.

The pressure roller of the above-explained structure generally showed surface potential not exceeding 100V (either positive or negative) and was completely free from electrostatic toner offsetting, without sacrificing the releasing ability of the surface.

In the following there will be explained still another embodiment of the present invention.

In this embodiment, the fixing roller is same as the roller coated with pure PFA resin, employed in the preceding embodiment, and the pressure roller has an elastic layer 2c, as shown in Fig. 5, composed of conductive silicone rubber containing the material of low resistance explained above in an amount of 30 ∼ 50%, and a surfacial releasing layer 2a composed of pure PFA resin.

The primer layers on both sides of the elastic layer are composed of a conventional insulating material. Also in this embodiment, the surface of the pressure roller is not significantly charged and is free from electrostatic toner offsetting.

In the following there will be explained a 4th embodiment of the present invention, in which the heat insulating material, supporting the metal core of the fixing roller as explained in the 2nd embodiment, is made electroinsulating, and the bearings 9 are composed of insulating material. The fixing roller is given a bias voltage of a polarity same as that of the toner. The pressure roller has an insulating and releasing surfacial layer, and the primer layer for adhering said surfacial layer to the elastic layer is composed of conductive primer containing the low-resistance material.

It is already known effective to provide the fixing roller with a bias voltage of a polarity same as that of the toner for the purpose of preventing the electrostatic toner offsetting, but said preventive effect is further enhanced in the present embodiment because the pressure roller is not charged. Also because the surface of the pressure roller is insulating and is free from charge transfer, there is no influence on the bias voltage supplied to the fixing roller and extremely stable performance can be maintained.

Following Table 3 shows the results of offset test and surface potential measurement on the paired rollers, on a reference example and the 2nd to 4th embodiments of the present invention. There were employed an ordinary text original document and negatively charged toner, and the results were obtained by passing 100 sheets consecutively. In Table 3, "F" indicates the fixing roller, and "P" indicates the pressure roller.

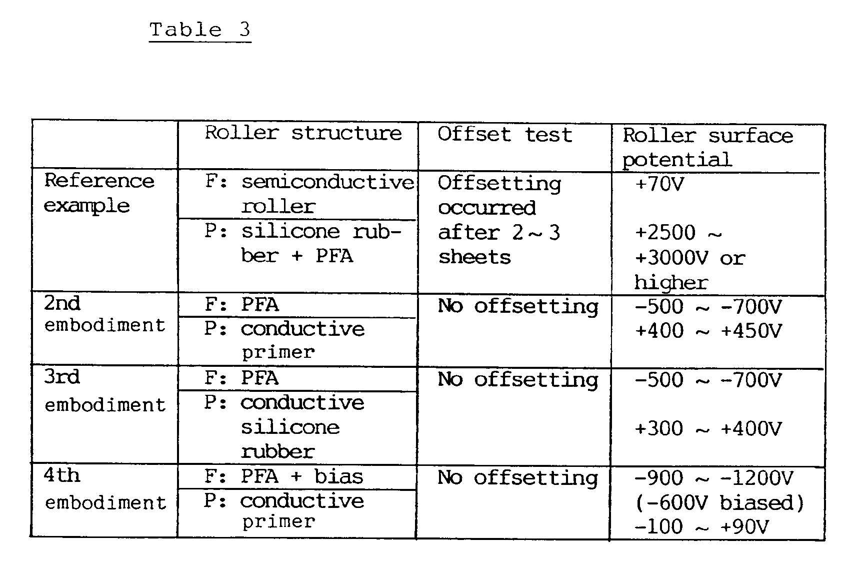

Table 3 indicates that the offset preventing effect of the embodiments of the present invention is far superior to that of the prior technology, and that the potentials of the rollers are low and stable. Also the use of pure PFA resin on the surface of the fixing roller allows to maintain the friction resistance and releasing ability, so that stable performance can be exhibited over a prolonged period.

In the following there will be explained a 5th embodiment of the present invention, wherein the structure of the fixing unit is same as that shown in Fig. 5.

The fixing roller 1 of the present embodiment is composed of a metal core 1c of a material of high electric and thermal conductivity such as stainless steel or aluminum, and a releasing layer 1a composed of tetrafluoroethylene (PTFE) resin containing a material of low resistance, for example carbon black, carbon fibers, graphite whiskers, silicon carbide fibers, silicon carbide whiskers, a metal oxide such as titanium oxide, or nickel, in an amount of 20 ∼ 40% and tetrafluoroethylenealkylvinylether copolymer resin (PFA) in an amount of 5 ∼ 15%, adhered onto said metal core by a primer layer lb composed of a rubber or resinous adhesive material. Said releasing layer 1a has a volume resistivity of 10¹¹ - 10¹⁴ Ω·cm due to the presence of material of low resistance mixed therein.

The pressure roller 2 is composed of a metal core 2d, an insulating rubber layer 2c formed thereon, and a surfacial releasing layer 2a of filler-free pure insulating fluorinated resin (for example perfluoroalkoxy (PFA) resin) adhered to said insulating rubber layer 2c by a primer layer 2b. This is same as the pressure roller employed in the 2nd embodiment.

Also this embodiment provides an excellent charging preventive effect because, as in the 1st embodiment, the surfacial layer of the fixing roller functions as the electrode in the capacitor model shown in Fig. 4, due to the presence of material of low resistance.

In the following there will be explained a 6th embodiment of the present invention, wherein the fixing roller is same as that in the 5th embodiment.

In the pressure roller, the elastic layer 2c on the metal core is composed of conductive silicone rubber of which volume resistivity is reduced to 10⁶ Ω·cm by mixing of material of low resistance in an amount of 30 ∼ 50%, and the surfacial releasing layer is composed of a pure PFA resin tube. The primer layers on both sides of the elastic layer are made insulating.

Also in this embodiment, the pressure roller is not significantly charged, and is free from toner offsetting.

In the following there will be explained a 7th embodiment of the present invention.

In this embodiment, as in the 4th embodiment, the fixing roller is supported by thermo- and electro-insulating bushings, and is given a bias voltage of a polarity same as that of the toner. In the pressure roller, a material of low resistance is added to the primer layer between the surfacial insulating and releasing layer and the insulating elastic layer, thereby reducing the volume resistivity of said primer layer to 10 Ω·cm or lower.

Following Table 4 shows the results of offset test and surface potential measurements of the paired rollers, on a reference example and the 5th to 7th embodiments of the present invention.

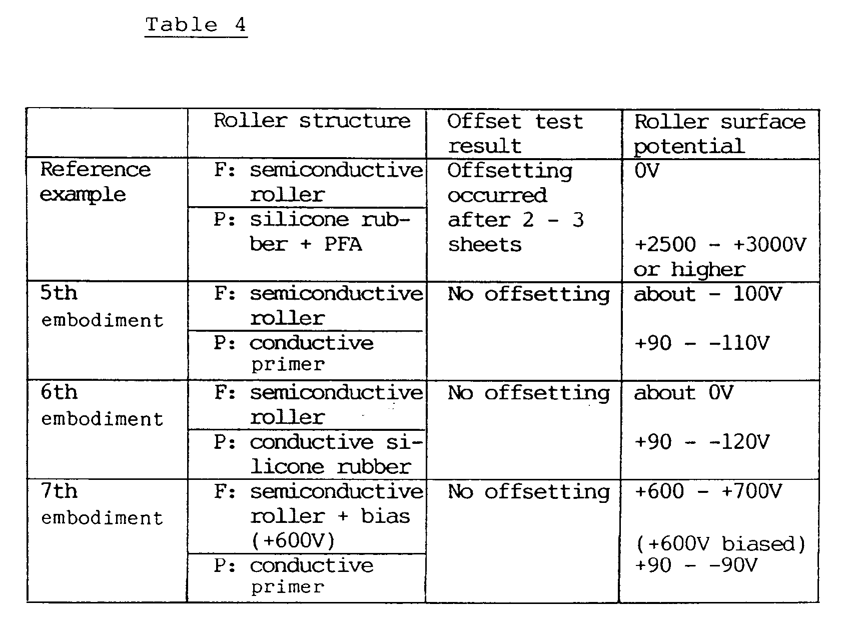

Results in Table 4 indicate that the effect of the embodiments of the present invention for preventing electrostatic toner offsetting is far superior to that of the reference example, and that the surface potentials of the rollers are low and stable. Particularly because of a semiconductive releasing layer of fluorinated resin containing material of low resistance in the surface layer, the fixing roller shows a very low potential, thereby being capable of preventing the electrostatic toner offsetting, and is particularly effective when positively charged toner is employed.

## Claims

1. A mold releasing elastic roller for use in a fixing device comprising a conductive core member (14), an electrically insulating rubber layer (7), an electrically insulating surface layer (20) which does not contain electrically conductive filling material, and a low resistance layer (6) located between the rubber layer and the surface layer, the low resistance layer having a volume resistivity equal or lower than 10³ Ω cm, and characterised in that the low resistance layer solely contacts the electrically insulating surface and rubber layers (20, 7) and thereby reduces
any surface potential induced during operation of the roller.

2. A mold releasing elastic roller according to claim 1, wherein said low resistance layer (6) has a volume resistivity equal to or lower than 10Ωcm.

3. A mold releasing elastic roller according to claim 1 or 2, wherein said low resistance layer (6) is a primer layer for adhering said surface layer to said rubber layer.

4. A mold releasing elastic roller according to any one of claims 1 to 3, wherein said surface layer (20) is made of pure fluorinated resin.

5. A mold releasing elastic roller according to claim 4, wherein the fluorinated resin is PFA.

6. A mold releasing elastic roller according to any one of claims 1 to 5, wherein said roller is adapted to convey a recording material which supports an unfixed image thereon.

7. A mold releasing elastic roller according to claim 6, wherein said roller in operation contacts with a surface opposite to a surface of the recording material which supports an unfixed image thereon.

## Patentansprüche

1. Adhäsionsfreie, elastische Walze für die Verwendung in einer Fixiervorrichtung, die ein leitendes Kernteil (14), eine elektrisch isolierende Gummischicht (7), eine elektrisch isolierende Oberflächenschicht (20), die kein elektrisch leitendes Füllmaterial enthält, und eine zwischen der Gummischicht und der Oberflächenschicht liegende Schicht (6) mit geringem elektrischen Widerstand aufweist, wobei die Schicht mit geringem elektrischen Widerstand einen spezifischen Volumenwiderstand gleich oder kleiner 1000 Ω·cm hat und dadurch gekennzeichnet ist, daß sie alleinig die elektrisch isolierende Schicht und die Gummischicht (20, 7) berührt und dabei jedes, während des Betriebes der Walze induzierte Oberflächenpotential reduziert.

2. Adhäsionsfreie, elastische Walze gemäß Anspruch 1, wobei die Schicht (6) mit geringem elektrischen Widerstand einen spezifischen Volumenwiderstand gleich oder kleiner 10 Ω·cm hat.

3. Adhäsionsfreie, elastische Walze gemäß Anspruch 1 oder 2, wobei die Schicht (6) mit geringem elektrischen Widerstand eine Grundierschicht zum Verbinden der Oberflächenschicht mit der Gummischicht ist.

4. Adhäsionsfreie, elastische Walze gemäß einem der Ansprüche 1 - 3, wobei die Oberflächenschicht (20) aus reinem fluoriertem Harz hergestellt ist.

5. Adhäsionsfreie, elastische Walze gemäß Anspruch 4, wobei das fluorierte Harz PFA ist.

6. Adhäsionsfreie, elastische Walze gemäß einem der Ansprüche 1-5, wobei die Walze als Transportmittel für ein Aufnahmematerial mit darauf aufgebrachtem, unfixierten Bild dient.

7. Adhäsionsfreie, elastische Walze gemäß Anspruch 6, wobei die sich in Betrieb befindliche Walze eine Oberfläche des Aufnahmematerials berührt, die der mit einem unfixierten Bild versehenen Oberfläche gegenüber liegt.

## Revendications

1. Rouleau élastique anti-adhérent utilisé dans un dispositif de fixage, comportant un noyau conducteur (14), une couche (7) de caoutchouc électriquement isolante, une couche superficielle (20) électriquement isolante qui ne contient pas de matière de charge électriquement conductrice, et une couche (6) à faible résistance placée entre la couche de caoutchouc et la couche superficielle, la couche à faible résistance ayant une résistivité volumique égale ou inférieure à 10³ Ω.cm, et caractérisé en ce que la couche à faible résistance est seulement en contact avec les couches (20, 7) superficielles et en caoutchouc, électriquement isolantes et, ainsi, réduit tout potentiel de surface induit pendant le fonctionnement du rouleau.

2. Rouleau élastique anti-adhérent selon la revendication 1, dans lequel ladite couche (6) à faible résistance présente une résistivité volumique égale ou inférieure à 10 Ω.cm.

3. Rouleau élastique anti-adhérent selon la revendication 1 ou 2, dans lequel ladite couche (6) à faible résistance est une couche d'apprêt destinée à faire adhérer ladite couche superficielle à ladite couche de caoutchouc.

4. Rouleau élastique anti-adhérent selon l'une quelconque des revendications 1 à 3, dans lequel ladite couche superficielle (20) est formée d'une résine fluorée pure.

5. Rouleau élastique anti-adhérent selon la revendication 4, dans lequel la résine fluorée est une résine PFA.

6. Rouleau élastique anti-adhérent selon l'une quelconque des revendications 1 à 5, dans lequel ledit rouleau est conçu pour transporter un support d'enregistrement qui supporte une image non fixée.

7. Rouleau élastique anti-adhérent selon la revendication 6, dans lequel ledit rouleau, en fonctionnement, est en contact avec une surface opposée à une surface du support d'enregistrement qui supporte une image non fixée.
